(19) **Europäisches Patentamt**

**European Patent Office**

**Office européen des brevets**

(11) **EP 0 901 613 B1**

(12) **EUROPÄISCHE PATENTSCHRIFT**

(45) Veröffentlichungstag und Bekanntmachung des Hinweises auf die Patenterteilung:
**23.01.2002 Patentblatt 2002/04**

(21) Anmeldenummer: **97924964.6**

(22) Anmeldetag: **21.05.1997**

(51) Int Cl.$^7$: **G01J 1/42**, H01L 31/036

(86) Internationale Anmeldenummer:
**PCT/EP97/02576**

(87) Internationale Veröffentlichungsnummer:
**WO 97/45710 (04.12.1997 Gazette 1997/52)**

(54) **PHOTONENDETEKTOR UND VERFAHREN ZUR HERSTELLUNG DES PHOTONENDETEKTORS**

PHOTON DETECTOR AND METHOD OF MANUFACTURING IT

DETECTEURS DE PHOTONS ET PROCEDE DE PRODUCTION D'UN DETECTEUR DE PHOTONS

(84) Benannte Vertragsstaaten:
**AT BE CH DE DK ES FI FR GB GR IE IT LI LU MC NL PT SE**

(30) Priorität: **24.05.1996 DE 19621175**
**20.05.1997 DE 19720926**

(43) Veröffentlichungstag der Anmeldung:
**17.03.1999 Patentblatt 1999/11**

(73) Patentinhaber: **Deutsche Telekom AG**
**53113 Bonn (DE)**

(72) Erfinder:
• **KOOPS, Hans, Wilfried, Peter**
**D-64372 Ober-Ramstadt (DE)**
• **KAYA, Alexander**
**D-64289 Darmstadt (DE)**

(56) Entgegenhaltungen:
**DE-A- 4 234 671**     **US-A- 5 446 286**

**Beschreibung**

Die Erfindung betrifft einen Photonendetektor, bei dem zwischen elektrisch-leitfähigen Anschlüssen Material mit lichtabhängiger Leitfähigkeit angeordnet ist, und ein Verfahren zur Herstellung des Photonendetektors.

Zum Nachweis von Licht bzw. Photonen sind die verschiedensten Einrichtungen bekanntgeworden, beispielsweise Photozellen, bei denen in einem Hochvakuumgefäß die Photonen eine Emission von Elektronen aus einer Photokathode bewirken, oder Festkörperelemente, bei denen ein lichtabhängiger Widerstandswert in elektrische Signale umgewandelt wird. Beispiele für bekannte Photonendetektoren sind unter anderem in Photonendetektoren für UV L. Strüder, J. Kemmer, Neuartige Detektoren für die Röntgen-Astrophysik, Phys. Bl. 52 (1996) 21, MOS-CCD-Kameras der Elektronik-Industrien, Firmenkataloge und in Photo-Widerstände aus Halbleitermaterial: J.C. Gammel, H. Ohno, J.M. Ballantyne, "High Speed Photoconductive detectors using Ga InAs". IEEE j Quant. Electr. QE-17 (1981) 269-272 beschrieben. Die bekannten Einrichtungen reagieren teilweise träge auf den Lichteinfall, benötigen große Lichtintensitäten oder sind teuer in der Herstellung. Ferner ist aus US 5,446,286 ein sehr schneller Sensor bekannt, der dotierte Nanokristalle benutzt, die erforderliche Lichtempfindlichkeit jedoch nur für Röntgen- und UV-Strahlung erreicht. Ferner ist in DE 42 34 671 A1 die Herstellung von Netzwerken aus Nanokristallen beschrieben, die für verschiedene Sensoren vorgesehen sind, wobei die Nanokristalle nicht gegeneinander isoliert sind. Eine auswertbare Lichtempfindlichkeit ist nicht gegeben.

Aufgabe der vorliegenden Erfindung ist es, einen Photonendetektor anzugeben, der bereits bei geringen Lichtmengen auswertbare Signale ergibt und der mit einfachen Prozessen herstellbar ist.

Diese Aufgabe wird dadurch gelöst, daß das Material nanokristallines Verbundmaterial ist, bestehend aus segregierten metallisch leitfähigen Einkristalliten, die in einer nicht leitfähigen Matrix voneinander isoliert eingebettet sind. Vorzugsweise ist dabei vorgesehen, daß die Einkristallite Edelmetall-Einkristallite sind und/oder daß die Einkristallite eine Größe von wenigen Nanometern aufweisen.

Der erfindungsgemäße Photonendetektor hat den Vorteil, daß bei seiner Herstellung kein besonderes Grundmaterial mit Halbleitereigenschaften, beispielsweise extrem reines Silizium, benötigt wird. Es ist auch keine Anwendung von hochgenauen lithographischen Techniken erforderlich. Das nanokristalline Verbundmaterial kann auf beliebige isolierende Substanzen, wie beispielsweise Quarz, aufgebracht werden. Lediglich eine leitfähige Anschlußstruktur zum Messen des durch Photonen induzierten Stromes ist erforderlich. Abgesehen davon entfallen mehrere halbleiter-technologische Prozeßschritte, was die Herstellung der erfindungsgemäßen Photonendetektoren wesentlich verbilligt.

Nanokristallines Verbundmaterial ist beispielsweise beschrieben in: J.B. Pendry, Journal of Modern Optics, Vol. 42, No. 2 (Februar 1994), 209.

Schon geringste Mengen des Verbundmaterials reichen aus, um Photonen nachzuweisen. So wurde beispielsweise zu Versuchszwecken ein erfindungsgemäßer Photonendetektor hergestellt, bei welchem das nanokristalline Verbundmaterial die Form eines Drahtes von 2 µm Länge und einem Querschnitt von 100 nm x 100 nm aufweist. Als Ausgangsmaterial für die Deposition wurde Dimethyl-Gold-Trifluoro-Acetylacetonat verwendet. Der derart hergestellte erfindungsgemäße Photonendetektor zeigte bereits einen Photonenstrom an, wie ihn eine 60-Watt-Lampe in einem Meter Entfernung aussendet. Flächige Detektoren mit 2 µm x 2 µm Größe aus platin-haltigem Material zeigen ähnliche Leitfähigkeitsänderungen.

Mit dem erfindungsgemäßen Herstellungsverfahren wird unter anderem bewirkt, daß die Einkristallite ein null-dimensionales Elektronengas mit stark gequantelten Energieabständen besitzen.

Bei dem erfindungsgemäßen Verfahren zur Herstellung des Photonendetektors ist vorgesehen, daß das nanokristalline Verbundmaterial durch korpuskularstrahl-induzierte Deposition auf einen Träger aufgebracht wird, wobei als Ausgangsstoffe organo-metallische Verbindungen verwendet werden, die aufgrund ihres hohen Dampfdrucks auf der Oberfläche des Trägers adsorbiert sind. Insbesondere werden die Einkristallite dadurch gebildet, daß die mit einer Molekularstrahl-Einrichtung im Vakuum auf der Oberfläche des Substrats adsorbierten Schichten der organo-metallischen Verbindungen durch einen energiereichen Beschuß mit Korpuskularstrahlen in nanokristalline Verbindungen umgewandelt werden.

Vorzugsweise ist bei dem erfindungsgemäßen Verfahren vorgesehen, daß während des Beschusses die Temperatur des Substrats zwischen 0 °C und 100 °C beträgt und/oder daß die organo-metallische Verbindung ein Edelmetall, vorzugsweise Platin oder Gold, enthält. Besonders gute Ergebnisse werden mit dem erfindungsgemäßen Verfahren erzielt, wenn als Korpuskularstrahlen energiereiche Elektronenstrahlen verwendet werden.

Ausführungsbeispiele der Erfindung sind in der Zeichnung anhand mehrerer Figuren dargestellt und in der nachfolgenden Beschreibung näher erläutert. Es zeigt:

Fig. 1    eine schematische Darstellung mehrerer Einkristallite innerhalb des nanokristallinen Verbundmaterials,

Fig. 2    eine schematische Darstellung der Elektronenzustände in den Kristalliten zur Erläuterung der Entstehung des photonenabhängigen Stroms und

Fig. 3    zwei Ansichten eines erfindungsgemäßen Photonendetektors, der in großer Zahl rasterförmig angeordnet zur Bildaufnahme dient.

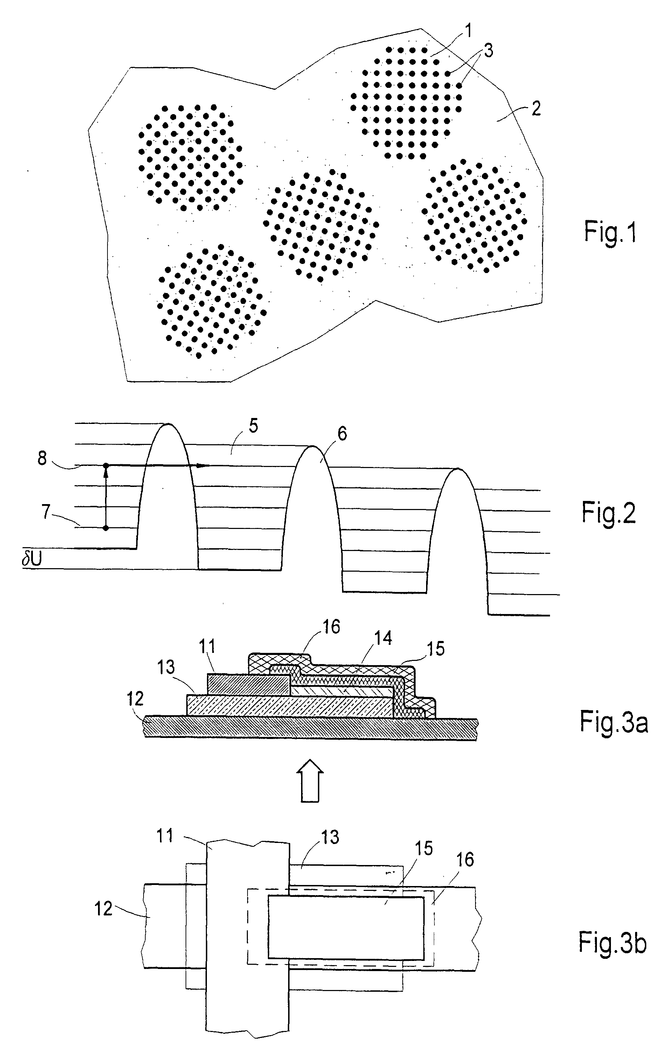

Fig. 1 zeigt schematisch nanokristallines Verbundmaterial, wie es bei dem erfindungsgemäßen Photonendetektor verwendet wird. Der Übersichtlichkeit halber wurde die Darstellung stark vereinfacht, beispielsweise dadurch, daß nur eine Ebene gezeigt ist und daß eine Kristallebene aller dargestellten Einkristallite in dieser Ebene liegt, was in Wirklichkeit nicht der Fall ist.

Auf der Oberfläche eines in Fig. 1 nicht dargestellten Substrats werden durch Korpuskularstrahl-Deposition Schichten aus organo-metallischen Verbindungen aufgebracht. Durch energiereichen lokalen oder flächigen Beschuß mit Korpuskularstrahlen hoher Energiedichte werden diese in nanokristalline Substanzen umgewandelt. Dabei befindet sich das Substrat auf Raumtemperatur oder auch auf erhöhter Temperatur von beispielsweise 100 °C. Die Temperaturerhöhung bewirkt das verstärkte Abdampfen organischer Radikale, die aus den organo-metallischen Verbindungen beim Molekül-Zerfall entstehen und die dadurch in verringertem Umfang in die Schicht eingebaut werden.

So entstehen besonders leitfähige Einkristallite 1, mit einem spezifischen Widerstand von nahe dem des reinen Metalls. Die Einkristallite weisen einen Durchmesser von 1 nm bis 4 nm auf und bestehen aus beispielsweise 600 Atomen, die in Fig. 1 als schwarze Punkte 3 dargestellt sind. Die Einkristallite 1 sind in einer Matrix 2 eingebettet, die von organischen Radikalen gebildet wird und praktisch nicht leitfähig ist.

Die Einkristallite besitzen ein null-dimensionales Elektronengas mit aufgrund der Quantenbedingungen für Elektronen-Eigenzustände in den Nanokristalliten stark gequantelten Energiezuständen definierter Energie-Abstände. Durch die Größe der Nanokristallite und durch ihre Abstände zueinander ist eine Aktivierungsenergie für die Wanderung der Elektronen durch Hüpfen zum nächsten Nachbarn (NNH = Nearest neighbor hopping) der Elektronen nach der Theorie von Mott meßbar, die über der bei Raumtemperatur von 20 °C zur Verfügung stehenden Energie von 27 meV liegt. Für Goldverbindungen beträgt die Aktivierungsenergie 20 meV bis 60 meV und liegt damit je nach Ausführungsform unter oder auch über der Anregungsenergie bei Raumtemperatur, während sie für platin-haltige Kristall-Verbundwerkstoffe je nach Herstellungsbedingungen zwischen 120 meV und 240 meV liegt. Entsprechend der Theorie für die Elektronenleitung durch Springen über variable Reichweite (VRH = Variable range hopping) folgt die bei verschiedenen Temperaturen gemessene Leitfähigkeit einem Exponentialgesetz

$$G = a \cdot T^{-\frac{1}{2}}.$$

Derartige nanokristalline Metalle mit nicht leitfähiger Matrix kommen in der Natur nicht vor, werden jedoch unter den besonderen Bedingungen der korpuskularstrahl-induzierten Deposition erzeugt.

Der erfindungsgemäße Photonendetektor kann als supergekühlte Materie angesehen werden, da Photonen von Raumtemperatur nicht genügend Energie besitzen, um die Elektronen anzuregen. Dieses ist wegen der großen Energieabstände > 27 meV, die im Bereich der niedrigen Anregungszustände besonders groß sind, im null-dimensionalen Elektronengas der Nanokristallite nicht möglich.

Photonen hingegen von Infrarot-Strahlung besitzen bereits mehr als 500 meV Energie und können daher die Elektronen leicht in energetisch höher liegende Zustände anheben, was in Fig. 2 durch den senkrechten Pfeil angedeutet ist. Die Elektronen in diesen Bändern besitzen Orbitale größerer räumlicher Ausdehnung als diejenigen niedrigerer Energie und daher ist es ein Leichtes, die hochangeregten Elektronen zu nächsten Nachbarn durch Anlegen einer geringen Spannung δU zu bewegen und so den Photostrom bzw. den Spannungsabfall bei konstantem Strom zu erhalten.

Den Effekt kann man ebenso dadurch erklären, daß die Potentialtöpfe 5 (Fig. 2) der Nanokristallite zum Vakuum hin oder zum Nachbarn hin durch die Bildkraft beim Tunneleffekt abgerundet sind. Damit müssen Elektronen aus Zuständen höherer Energie (beispielsweise 8) nur einen schmaleren Potentialwall 6 zum Nachbartopf hin durchtunneln, als stärker gebundene (beispielsweise 7), was den erhöhten Tunnelstrom erklärt. Damit stellen die nanokristallinen Verbundmaterialien eine neue Klasse von rauscharmen Photonendetektoren dar, die mit besonders einfachen Fertigungsbedingungen hergestellt werden können und kein hochreines Halbleitermaterial als Ausgangssubstanz erfordern.

Die nanokristallinen Verbundmaterialien können auf allen isolierenden Stoffen, wie Glas, Quarz, oder Kunststoffen, durch korpuskularstrahl-induzierte Deposition aufgebracht werden. Diese kann mit Einzelstrahlen oder auch durch mit Schablonen strukturierte Großflächenstrahler, wie reaktive Ätzanlagen und Plasma-Entladungen, oder auch in unstrukturierter Weise in Gasentladungen erzeugt werden. So können großflächige Photonendetektoren hohen Wirkungsgrades und hoher Empfindlichkeit erzeugt werden. Derartige Schichten sind für die Anwendung in der Photovoltaik zur Energieumwandlung von Licht in elektrische Energie einsetzbar.

Werden durch geeignete Wahl der Prekursoren und Ausgangsmaterialien und der Depositionsbedingungen Stoffe mit metastabilen Zuständen erzeugt, so lassen sich auf diese Weise strukturierte oder auch unstrukturierte Laser-Materialien als Ausgangsstoffe für Laser und schmalbandige Lichtquellen herstellen und in Strukturen einfügen, die in der integrierten Optik und in Schaltungen für das Schalten von und das Rechnen mit Licht von großer Bedeutung sind.

Da der Leitungsmechanismus auf Hüpfen bzw. Tunneln von Elektronen basiert und dieser Prozeß der schnellste für Elektronenbewegung ist, stellen diese neuartigen Photonendetektoren aus Verbundwerkstoffen mit eindimensionalem Elektronengas sehr schnelle Detektoren dar, wie sie in der optischen Nachrichtentechnik und Signalverarbeitung im GHz-Bereich. benötigt werden.

Für das Rechnen mit Licht und die kontrollierte Emission von Licht mit definierten Pulsfolgen und -längen wird ein schneller Detektor benötigt, um durch kontrollierte schnelle Eingriffe bei der Emission der Lichtwellen mit Hilfe von deterministischem Chaos Licht besonderer Eigenschaften herzustellen.

Die Figuren 3a und 3b zeigen einen Photonendetektor, der einen Punkt eines Flächensensors einer Bildaufnahmeeinrichtung bildet, und zwar Fig. 3a in Form eines Querschnitts, Fig. 3b als Ansicht von der Rückseite. Der Photonendetektor befindet sich am Kreuzungspunkt zweier ITO-Leiterbahnen 11, 12, die von einem Isolator 13 getrennt sind. Zur Farbselektion ist eine dielektrische Fabfilterschicht 14 vorgesehen, die in Einfallsrichtung des Lichts (Pfeil) vor der lichtempfindlichen Schicht 15 aus nanokristallinem Verbundmaterial aufgebracht ist. Rückwärtig ist die lichtempfindliche Schicht 15 mit einem dielektrischen Spiegel 16 abgedeckt, um Störungen durch von der Rückseite einfallendes Licht zu verhindern. Der dielektrische Spiegel 16 ist in Fig. 3b lediglich gestrichelt angedeutet, um den Blick auf die lichtempfindliche Schicht 15 freizugeben.

## Patentansprüche

1. Photonendetektor, bei dem zwischen elektrisch-leitfähigen Anschlüssen Material mit lichtabhängiger Leitfähigkeit angeordnet ist, **dadurch gekennzeichnet, daß** das Material nanokristallines Verbundmaterial ist, bestehend aus segregierten metallisch leitfähigen Einkristalliten (1), die in einer nicht leitfähigen Matrix (2) voneinander isoliert eingebettet sind.

2. Photonendetektor nach Anspruch 1, **dadurch gekennzeichnet, daß** die Einkristallite (1) Edelmetall-Einkristallite (1) sind.

3. Photonendetektor nach Anspruch 2, **dadurch gekennzeichnet, daß** die Einkristallite (1) eine Größe von wenigen Nanometern aufweisen.

4. Photonendetektor nach einem der vorhergehenden Ansprüche, **dadurch gekennzeichnet, daß** die Einkristallite (1) ein null-dimensionales Elektronengas mit stark gequantelten Energieabständen besitzen.

5. Verfahren zur Herstellung des Photonendetektors nach einem der vorhergehenden Ansprüche, **dadurch gekennzeichnet, daß** das nanokristalline Verbundmaterial, bestehend aus segregierten metallisch leitfähigen Einkristalliten (1), die in einer nicht leitfähigen Matrix (2) voneinander isoliert eingebettet sind, durch korpuskularstrahl-induzierte Deposition auf einen Träger aufgebracht wird, wobei als Ausgangsstoffe organo-metallische Verbindungen verwendet werden, die aufgrund ihres hohen Dampfdrucks auf der Oberfläche des Trägers adsorbiert sind.

6. Verfahren nach Anspruch 5, **dadurch gekennzeichnet, daß** die mit einer Molekularstrahl-Einrichtung im Vakuum auf der Oberfläche des Substrats adsorbierten Schichten der organo-metallischen Verbindungen durch einen energiereichen Beschuß mit Korpuskularstrahlen in nanokristalline Verbindungen umgewandelt werden.

7. Verfahren nach einem der Ansprüche 5 oder 6, **dadurch gekennzeichnet, daß** während des Beschusses die Temperatur des Substrats zwischen 0 °C und 100 °C beträgt.

8. Verfahren nach einem der Ansprüche 5 bis 7, **dadurch gekennzeichnet, daß** die organo-metallische Verbindung ein Edelmetall, vorzugsweise Platin oder Gold, enthält.

9. Verfahren nach einem der Ansprüche 5 bis 8, **dadurch gekennzeichnet, daß** als Korpuskularstrahlen energiereiche Elektronenstrahlen verwendet werden.

## Claims

1. Photon detector in which material of light-dependent conductivity is disposed between electrically conductive terminals, **characterized in that** the material is nanocrystalline composite material, consisting of segregated metallically conductive monocrystallites (1) which are embedded, insulated from each other, in a non-conductive matrix (2).

2. Photon detector according to claim 1, **characterized in that** the monocrystallites (1) are precious-metal monocrystallites (1).

3. Photon detector according to claim 2, **characterized in that** the monocrystallites (1) have a size of a few nanometres.

4. Photon detector according to any one of the preceding claims, **characterized in that** the monocrystallites (1) possess a zero-dimensional electron gas with heavily quantized energy gaps.

5. Process for the production of the photon detector according to any one of the preceding claims, **characterized in that** the nanocrystalline composite material, consisting of segregated metallically conductive monocrystallites (1) which are embedded, insulated from each other, in a non-conductive matrix (2), is applied to a substrate by corpuscular-beam-induced deposition, the starting materials used being organometallic compounds which are adsorbed on the surface of the substrate on account of their high vapour pressure.

6. Process according to claim 5, **characterized in that** the layers of organometallic compounds, adsorbed on the surface of the substrate using a molecular-beam apparatus in a vacuum, are converted into nanocrystalline compounds through high-energy bombardment with corpuscular beams.

7. Process according to any one of claims 5 and 6, **characterized in that**, during bombardment, the temperature of the substrate is between 0°C and 100°C.

8. Process according to any one of claims 5 to 7, **characterized in that** the organometallic compound contains a precious metal, preferably platinum or gold.

9. Process according to any one of claims 5 to 8, **characterized in that** high-energy electron beams are used as corpuscular beams.

**Revendications**

1. Détecteur de photons, dans lequel un matériau dont la conductivité dépend de la lumière est placé entre des raccordements électriquement conducteurs, **caractérisé en ce que** le matériau est un matériau composé nanocristallin, constitué de monocristallites ségrégués à conductivité métallique (1), qui sont placés, isolés les uns des autres, dans une matrice non conductrice (2).

2. Détecteur de photons selon la revendication 1, **caractérisé en ce que** les monocristallites (1) sont des monocristallites en métal précieux (1).

3. Détecteur de photons selon la revendication 2, **caractérisé en ce que** les monocristallites (1) ont une taille de quelques nanomètres seulement.

4. Détecteur de photons selon l'une des revendications précédentes, **caractérisé en ce que** les monocristallites (1) comprennent un gaz électronique à dimension zéro avec des différences de niveau d'énergie rigoureusement quantifiées.

5. Procédé de fabrication du détecteur de photons selon l'une des revendications précédentes, **caractérisé en ce que** le matériau composé nanocristallin constitué de monocristallites ségrégués à conductivité métallique (1), placés, isolés les uns des autres, dans une matrice non conductrice (2), est appliqué sur un support par précipitation induite par rayonnement corpusculaire, les matériaux de départ utilisés étant des composés organo-métalliques qui, en raison de leur forte pression de vaporisation, sont fixés par adsorption sur la surface du support.

6. Procédé selon la revendication 5, **caractérisé en ce que** les couches des composés organo-métalliques adsorbées dans le vide à la surface du substrat à l'aide d'un dispositif à rayons moléculaires sont transformées en composés nanocristallins par bombardement corpusculaire à haute énergie.

7. Procédé selon l'une des revendications 5 ou 6, **caractérisé en ce que** la température du substrat pendant le bombardement est comprise entre 0°C et 100 °C.

8. Procédé selon l'une des revendications 5 à 7, **caractérisé en ce que** le composé organo-métallique contient un métal précieux, de préférence du platine ou de l'or.

9. Procédé selon l'une des revendications 5 à 8, **caractérisé en ce que** les rayons corpusculaires utilisés sont des rayons électroniques à haute énergie.

Fig.1

1

3

2

5

6

8

7

$\delta U$

Fig.2

16

11

13

12

14

15

Fig.3a

11

13

15

16

12

Fig.3b